Europäisches Patentamt

European Patent Office

Office européen des brevets

(19)

(11) **EP 1 293 042 B1**

(12) **EUROPÄISCHE PATENTSCHRIFT**

(45) Veröffentlichungstag und Bekanntmachung des
Hinweises auf die Patenterteilung:
**17.12.2003 Patentblatt 2003/51**

(21) Anmeldenummer: **01945293.7**

(22) Anmeldetag: **21.06.2001**

(51) Int Cl.⁷: $H03K\ 17/00$

(86) Internationale Anmeldenummer:
**PCT/EP01/07040**

(87) Internationale Veröffentlichungsnummer:
**WO 01/099280 (27.12.2001 Gazette 2001/52)**

(54) **VERFAHREN UND SCHALTUNGSVORRICHTUNG ZUR ANSTEUERUNG EINER MEHRZAHL VON SCHALTUNGEN**

METHOD AND SWITCHING DEVICE FOR CONTROLLING A PLURALITY OF CIRCUITS

PROCEDE ET DISPOSITIF DE COMMUTATION DESTINES A LA COMMANDE D'UNE PLURALITE DE CIRCUITS

(84) Benannte Vertragsstaaten:
**AT BE CH CY DE DK ES FI FR GB GR IE IT LI LU MC NL PT SE TR**

(30) Priorität: **23.06.2000 DE 10030752**

(43) Veröffentlichungstag der Anmeldung:
**19.03.2003 Patentblatt 2003/12**

(73) Patentinhaber: **Fraunhofer-Gesellschaft zur Förderung der angewandten Forschung e.V. 80686 München (DE)**

(72) Erfinder: **EICHHOLZ, Jörg 25560 Warringholz (DE)**

(74) Vertreter: **Schoppe, Fritz, Dipl.-Ing. et al Patentanwälte Schoppe, Zimmermann, Stöckeler & Zinkler, Postfach 246 82043 Pullach bei München (DE)**

(56) Entgegenhaltungen:
DE-C- 538 650          US-A- 3 624 510
US-A- 5 027 709

• "Schaltungssammlung Heft 2" Juni 1972 (1972-06) , VALVO GMBH , HAMBURG XP002174744 Seite 134 -Seite 135
• H. RICHTER: "Neues Bastelbuch für Radio und Elektronik" 1966 , FRANCKH'SCHE VERLAGSBUCHHANDLUNG, E. KELLER & CO. , STUTTGART XP002174745 Seite 135 -Seite 136; Abbildung 63 Seite 145 -Seite 149; Abbildungen 70,71
• H. JAKUBASCHK: "Das grosse Elektronikbastelbuch, 3. Auflage" 1968 , DEUTSCHER MILITÄRVERLAG XP002174746 Seite 154 -Seite 156; Abbildung 6.12

**Beschreibung**

Die vorliegende Erfindung bezieht sich auf ein Verfahren und eine Schaltungsvorrichtung zur Ansteuerung einer Mehrzahl von Schaltungen, und insbesondere auf eine wahlfreie Ansteuerung einer oder mehrerer energieloser integrierter Schaltungen (ICs = Integrated Circuits), die nur über eine gemeinsame Leitung angeschlossen sind.

Bei bekannten Schaltungsvorrichtungen tritt ein Problem auf, wenn eine Mehrzahl von integrierten Schaltungen angesteuert werden muß, welche über eine gemeinsame Leitung mit einem zentralen Ansteuerelement verbunden sind. Solche Schaltungen, z.B. EEPROMS (EEPROMs = Electrically Eraseable Programmable Read Only Memory = elektrisch löschbarer Festwertspeicher), dienen als Schaltelemente bzw. Schalter dazu, Sensoren, die mit diesen Schaltungen verbunden sind, auswahlmäßig mit dem zentralen Ansteuerelement zu verbinden, um dieselben auszulesen, zu aktivieren oder dergleichen.

Es existiert im Stand der Technik keine Möglichkeit jede der integrierten Schaltungen einzeln anzusprechen, so daß keine Möglichkeit existiert, nur diejenige integrierte Schaltung mit Energie zu versorgen, welche anzusteuern ist.

Ein weiteres Problem bei der Ansteuerung von integrierten Schaltungen, welche über eine gemeinsame Leitung mit einem zentralen Steuerelement verbunden sind, besteht darin, daß die integrierten Schaltungen im Regelfall weitere Elemente, wie z.B. die bereits angesprochenen Sensoren oder ähnliches, aufweisen oder zur Verbindung mit diesen zwischen das zentrale Steuerelement und dieselben geschaltet sind, die entsprechende elektrische Nutzsignale erzeugen, so daß sichergestellt werden muß, daß durch die Ansteuerung der einzelnen integrierten Schaltung keine Beeinträchtigung oder dauerhafte Veränderung der erzeugten Nutzsignale hervorgerufen wird.

Aus Dokument JP-A-05 203 512 ist eine Schaltungsvorrichtung zur Ansteuerung einer Mehrzahl von Schaltungen bekannt, die über eine gemeinsame Verbindung zum Empfangen eines Ansteuersignals miteinander verbunden sind. Die Schaltungen umfassen jeweils ein Schaltungselement und einen Sensor, wobei das Schaltungselement eine Resonanzfrequenz für die Schaltung definiert und wobei zumindest zwei Schaltungen unterschiedliche Resonanzfrequenzen haben. Ferner ist ein Steuerelement vorgesehen, das über die gemeinsame Verbindung mit der Mehrzahl der Schaltungen verbunden ist, und das abhängig von einer anzusteuernden Schaltung ein Ansteuersignal mit einer Frequenz erzeugt, die der der anzusteuernden Schaltung zugeordneten Resonanzfrequenz entspricht und das Ansteuersignal an die gemeinsame Verbindung anlegt, um einen Sensor mit der gemeinsamen Verbindungsleitung zu verbinden.

Ausgehend von diesem Stand der Technik liegt der vorliegenden Erfindung die Aufgabe zugrunde, ein Verfahren und eine Schaltungsvorrichtung zu schaffen, welche eine wahlfreie Ansteuerung einer oder mehrerer Schaltungen, die nur über eine gemeinsame Leitung angeschlossen sind, ermöglicht.

Diese Aufgabe wird durch ein Verfahren gemäß Anspruch 1 und durch eine Vorrichtung gemäß Anspruch 6 gelöst. Bevorzugte Ausführungsbeispiele ergeben sich aus den abhängigen Ansprüchen.

Gemäß der vorliegenden Erfindung wird das Ansteuersignal derart erzeugt, daß dasselbe eine Signalamplitude aufweist, die unterhalb einer vorbestimmten Schwelle liegt, wobei diese vorbestimmte Schwelle vorzugsweise durch ein in den einzelnen Schaltungen verwendetes Nutzsignal festgelegt ist. Abhängig von der erwünschten Konfiguration können sämtliche Schaltungen unterschiedliche Resonanzfrequenzen aufweisen. Sofern es erwünscht ist, mehrere Schaltungen gleichzeitig anzusteuern, sind diese derart ausgelegt, daß sie die gleiche Resonanzfrequenz haben.

Das erfindungsgemäße Verfahren und die erfindungsgemäße Schaltungsvorrichtung dienen zur Ansteuerung von Schaltelementen, um Sensoren, die über die einzelnen Schalter mit der gemeinsamen Leitung verbunden sind, mit dem Steuerelement zu verbinden. Hierzu wird das Ansteuersignal an das Schaltungselement eines Schalters angelegt und durch Multiplizieren des Ansteuersignals mit einem durch das Schaltungselement definierten Faktor wird ein Ausgangssignal des Schaltungselements erzeugt, welches zur Erzeugung eines Batteriesignals herangezogen wird. Dieses Batteriesignal wird an ein Schaltelement angelegt, um dieses zwischen dessen Schaltzuständen umzuschalten, um so den in der Schaltung enthaltenen Sensor mit dem Steuerelement zu verbinden oder von diesem zu trennen. Hat das auf der gemeinsamen Verbindung auftretende Ansteuersignal eine Frequenz, die unterhalb oder oberhalb der Resonanzfrequenz einer der Schaltungen liegt, so ist das durch das Schaltelement erzeugte Ausgangssignal zu niedrig, um eine Umprogrammierung der Schaltung durchzuführen.

Vorzugsweise wird das Batteriesignal durch Gleichrichten des Ausgangssignals des Schaltungselements mittels eines Gleichrichters und durch Aufladen eines Kondensators durch das gleichgerichtete Ausgangssignal erzeugt.

Gemäß einem weiteren bevorzugten Ausführungsbeispiel der vorliegenden Erfindung ist das Schaltungselement durch einen Serienschwingkreis oder einem Parallelschwingkreis ausgebildet, und der Faktor zum Erzeugen des Ausgangssignals des Schaltungselements ist durch die Güte der Schwingkreise bestimmt.

Vorzugsweise erfolgt die Entladung der anliegenden Batteriesignale durch Leckströme, und weiterhin vorzugsweise, handelt es sich bei den angesprochenen Schaltungen um Energieversorgungs-freie Schaltungen.

Gemäß einem weiteren, bevorzugten Ausführungsbeispiel ist ein Regelelement vorgesehen, welches den Stromfluß aus dem Steuerelement erfaßt, um die der Resonanzfrequenz der zugeordneten Schaltung entsprechenden Frequenz des Ansteuersignals zu finden und zu halten.

Der Vorteil der vorliegenden Erfindung besteht darin, daß bei integrierten Schaltungen, welche beispielsweise keine Energieversorgung aufweisen, eine Möglichkeit existiert, jede der Mehrzahl von integrierten Schaltungen einzeln anzusprechen. Ein weiterer Vorteil besteht darin, daß nur diejenige Schaltung, welche umprogrammiert werden soll, z.B. an- oder abgeschaltet wird, mit Energie versorgt wird, wodurch sich Energie einsparen läßt.

Wiederum ein weiterer Vorteil der vorliegenden Erfindung besteht darin, daß die erforderliche Energieaufladung der integrierten Schaltung mittels Energieimpulsen durchgeführt werden kann, die so klein sind, daß sie ein Nutzsignal, welches über angeschlossene Sensoren erfaßt wird, nicht beeinträchtigen oder dauerhaft verändern.

Bevorzugte Ausführungsbeispiele der vorliegenden Erfindung werden nachfolgend anhand der beiliegenden Zeichnungen näher erläutert. Es zeigen:

Fig. 1 eine schematische Darstellung der erfindungsgemäßen Schaltungsvorrichtung;

Fig. 2 eine Darstellung der den jeweiligen Schaltungen zugeordneten Resonanzfrequenzen;

Fig. 3 ein bevorzugtes Ausführungsbeispiel für die den Schaltungen zugeordneten Schaltungselemente in der Form eines Serienschwingkreises; und

Fig. 4 ein Beispiel für eine Schaltung zur Erzeugung der Batteriespannung.

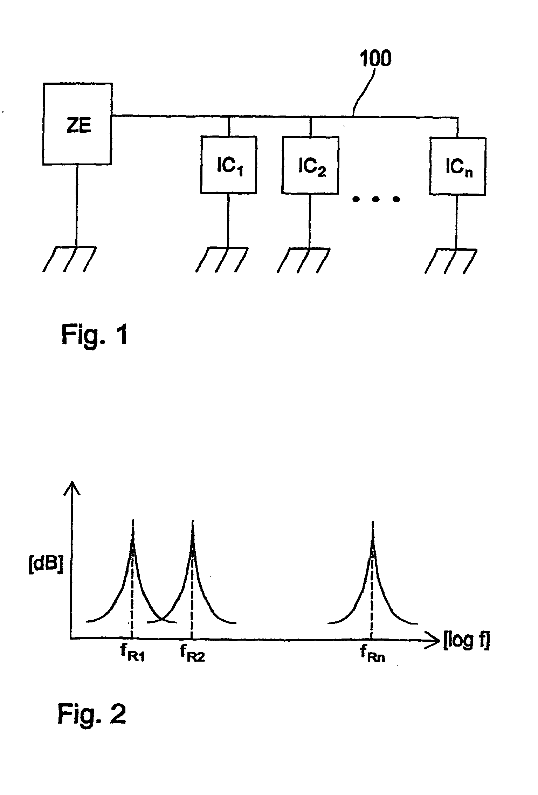

In Fig. 1 ist eine schematische Darstellung der erfindungsgemäßen Schaltungsvorrichtung dargestellt, die eine Mehrzahl von Schaltungen $IC_1$, $IC_2$, ..., $IC_n$ umfaßt. Ferner ist ein Steuerelement ZE vorgesehen. Sowohl die einzelnen Schaltungen als auch das Steuerelement ZE umfassen einen ersten und einen zweiten Anschluß, wobei einer der Anschlüsse mit Masse verbunden ist. Der andere Anschluß der Elemente ist mit einer gemeinsamen Leitung 100 verbunden. Wie zu erkennen ist, sind mehrere integrierte Schaltungen $IC_1$, $IC_2$, ..., $IC_n$ mit einer zentralen Elektronik ZE (Steuerelement) über die elektrische Leitung 100 verbunden, wobei der erforderliche zweite Kontakt über die gemeinsame Masse hergestellt ist.

Gemäß einem Ausführungsbeispiel werden die integrierten Schaltungen $IC_1$, $IC_2$, ..., $IC_n$ als Schalter genutzt, um Sensoren, die mit diesen verbunden sind, über die Leitung 100 mit der zentralen Elektronik ZE zu verbinden oder von derselben zu trennen.

Bei einem bevorzugten Ausführungsbeispiel handelt es sich bei dem gezeigten integrierten Schaltungen $IC_1$, $IC_2$, ..., $IC_n$ um elektrisch löschbare Festwertspeicher (EEPROMs = Electrically Eraseable Programmable Read only Memory). Die EEPROM-Technologie bietet die Möglichkeit, einen Transistor als Schalter zu programmieren, derart, daß der Schalter entweder geöffnet oder geschlossen ist, und diesen Zustand ohne weitere äußere Energiezufuhr dauerhaft zu halten.

Jede Schaltung $IC_1$, $IC_2$, ..., $IC_n$ enthält ein Schaltungselement, wobei zumindest zwei Schaltungen unterschiedliche Resonanzfrequenzen aufweisen. Bei dem dargestellten Ausführungsbeispiel hat jedes Schaltungselement eine unterschiedliche Resonanzfrequenz $f_{R1}$, $f_{R2}$, ... , $f_{Rn}$, so daß jeder Schaltung $IC_1$, $IC_2$, ..., $IC_n$ eine unterschiedliche Resonanzfrequenz zugeordnet ist, wie dies in Fig. 2 dargestellt ist.

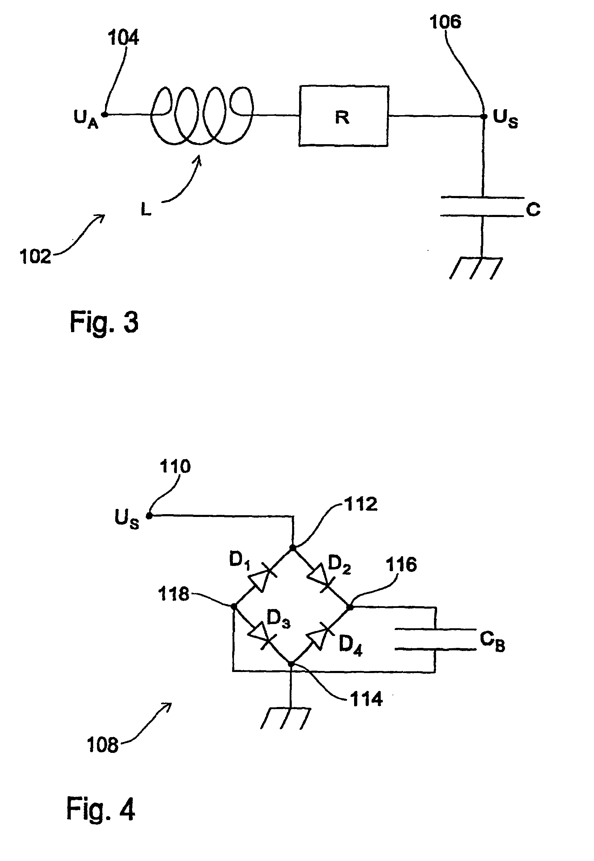

Ein Beispiel für die den Schaltungen $IC_1$, $IC_2$, ..., $IC_n$ zugeordneten Schaltungselemente ist in Fig. 3 gezeigt, und dort in seiner Gesamtheit mit den Bezugszeichen 102 versehen. Das Schaltungselement 102 ist ein Serienschwingkreis, der zwischen einem Eingangsknoten 104 und Masse durch eine Serienschaltung eines induktiven Elements L, eines Widerstands R und eines Kondensators C gebildet ist. Am Knoten 104 liegt das Ansteuersignal $U_A$ an, und an einem Knoten 106 ist ein Schwingkreissignal $U_S$ als Ausgangssignal des Schaltungselements abgreifbar.

Gemäß dem Ausführungsbeispiel der vorliegenden Erfindung enthält jede der Schaltungen $IC_1$, $IC_2$, ..., $IC_n$ einen Schwingkreis, wie er in Fig. 3 dargestellt ist. Jeder dieser Schwingkreise hat eine andere Resonanzfrequenz, wie dies in Fig. 2 erläutert wurde, so daß jeder der Schwingkreise durch die zentrale Elektronik ZE (Fig. 1) einzeln über die Wahl der Frequenz des Ansteuersignals angesprochen werden kann.

Wählt man den in Fig. 3 dargestellten Reihenschwingkreis mit einer Güte

$$Q = \omega_0 \, L/R = 1 / (\omega_0 RC)$$

mit einer Resonanzfrequenz

$$\omega_0 = (LC)^{-\frac{1}{2}},$$

so erhält man in Resonanz eine Spannungsüberhöhung am inneren Knoten 106, die Q-mal höher ist als die Spannung, mit der die zentrale Elektronik ZE den Schwingkreis 102 über die elektrische Leitung 100 anregt, es gilt also:

$$U_S = Q \cdot U_A.$$

Diese erfindungsgemäße Ausgestaltung ermöglicht es, die anregende Spannung $U_A$, das Ansteuersignal, unter einem Grenzwert des zu messenden elektrischen Signals zu halten. Trotzdem steht der Schaltung eine Spannung zur Verfügung, die zur Ansteuerung weiterer Elemente, wie beispielsweise des Transistors, herangezogen wird.

Um beispielsweise ein entsprechendes Spannungssignal für die Ansteuerung eines Transistorelements in dem EEPROM zu erzeugen, wird die in Fig. 4 gezeigte Gleichrichterspannung 108 verwendet. Die Schaltung 108 empfängt an einem ersten Knoten 110 das Schwingkreissignal $U_S$, welches an eine Brückenschaltung aus vier Dioden $D_1$, $D_2$, $D_3$ und $D_4$ angelegt wird. Das Signal $U_S$ wird an einen ersten Anschluß 112 der Brückenschaltung angelegt. Ein zweiter Anschluß 114 der Brückenschaltung ist mit einem Bezugspotential, z.B. Masse oder $U_A$, verbunden. Zwischen die Anschlüsse 116 und 118 der Brückenschaltung ist der Batteriekondensator $C_B$ geschaltet, der über das gleichgerichtete Schwingkreissignal aufgeladen wird.

Wie erwähnt, wird durch den Schwingkreis 102 (Fig. 3) der integrierten Schaltung eine Spannung zur Verfügung gestellt, mit der mittels der in Fig. 4 gezeigten Gleichrichterschaltung 108 der Kondensator $C_B$ aufgeladen werden kann, der dann für kurze Zeit die Energieversorgung zur Umprogrammierung der integrierten Schaltung bereitstellt. Nach der Umprogrammierung des zentralen EEPROM-Schalters entlädt sich die integrierte Schaltung durch Leckströme von selbst, und die nächste integrierte Schaltung kann im Bedarfsfall programmiert werden.

Zusätzlich zu den in Fig. 1 beschriebenen Schaltungselementen kann ferner ein Regelkreis vorgesehen sein, der den Stromfluß aus der zentralen Elektronik ZE mißt, so daß die Ausgangsfrequenz des Ausgangssignals auf eine Frequenz geführt und auf derselben gehalten werden kann, die der Resonanzfrequenz der anzusteuernden Schaltung entspricht. Diese Regelung des Ausgangssignals aus der zentralen Elektronik ist vorteilhaft, da im Resonanzfall die Aufladung des Kondensators $C_B$ (siehe Fig. 4), d.h. die Energieaufnahme und damit der Stromfluß, am größten ist.

Wie aus der obigen Erläuterung deutlich wird, bietet die vorliegende Erfindung den Vorteil, daß aufgrund der Tatsache, daß jeder integrierten Schaltung eine eigene Resonanz zugeordnet ist, möglich ist, jede integrierte Schaltung einzeln anzusprechen. Ein weiterer Vorteil der vorliegenden Erfindung besteht darin, daß diese die Nutzung einer Signalamplitude zur Energieübertragung ermöglicht, die deutlich unterhalb einer, durch das Nutzsignal in den Schaltungen bestimmten Schwelle liegt. Ferner wird durch die Ausnutzung des Schwingkreises 102 und der Gleichrichterschaltung 108 mit dem Ladekondensator $C_B$ die Erzeugung einer Batteriespannung ermöglicht, die deutlich höher ist, als die Signalspannung des Ansteuersignals. Ein weiterer Vorteil besteht darin, daß durch die Nutzung des Regelkreises der Strom dahingehend gesteuert wird, daß das Ansteuersignal auf eine Frequenz eingestellt und auf derselben gehalten wird, die der Resonanzfrequenz der anzusteuernden Schaltung entspricht. Das Deaktivieren einer integrierten Schaltung erfolgt vorzugsweise durch ein zeitkontrolliertes Selbstentladen des Batteriekondensators $C_B$.

Ein bevorzugtes Ausführungsbeispiel und Anwendungsbeispiel für das erfindungsgemäße Verfahren und die erfindungsgemäße Schaltungsvorrichtung ist das Gebiet der Herzschrittmachertechnik. Bei einem Herzschrittmacher, der die zentrale Elektronik ZE, also das Steuerelement, darstellt sind mehrere Elektroden (Sensoren) am Herzen verteilt angeordnet. Die Elektroden sind alle gemeinsam über eine elektrische Leitung mit dem Schrittmacher verbunden. Die Elektroden dienen zur Messung der Herzaktivität und zur Durchleitung anregender Elektroimpulse im Falle, daß eine Stimulanz des Herzens erforderlich ist. Hierbei sollen jedoch nicht alle, sondern wahlweise eine oder auch mehrere Elektroden mit dem Schrittmacher verbunden sein, die anderen werden abgeschaltet. Als Schalter dienen hierzu die obenbeschriebenen integrierten Schaltungen. Die Programmierung, d.h. das Senden der Resonanzfrequenzen muß dabei in der Spannungsamplitude so gering sein, daß das Herz dadurch nicht angeregt wird.

Durch die obenbeschriebene erfindungsgemäße Ansteuerungstechnik wird sichergestellt, daß die Spannungsamplitude des Ansteuersignals zu keiner Anregung des Herzen führt, nachdem die erfindungsgemäße Schaltungsvorrichtung und das erfindungsgemäße Verfahren es ermöglichen, die Ansteuersignalamplitude ausreichend niedrig zu halten.

**Patentansprüche**

1. Verfahren zur Ansteuerung einer Mehrzahl von Schaltungen ($IC_1$, $IC_2$, ...., $IC_n$), die über eine gemeinsame Verbindung (100) zum Empfangen eines Ansteuersignals ($U_A$) miteinander verbunden sind, wobei jede der Mehrzahl von Schaltungen einen Schalter und einen Sensor, der ein Nutzsignal erzeugt, das an die gemeinsame Verbindungsleitung anlegbar ist, umfaßt, wobei der Schalter ein Schaltelement sowie ein Schaltungselement (102) umfaßt, wobei das Schaltungselement (102) eine Resonanzfrequenz ($f_{R1}$, $f_{R2}$, ..., $f_{Rn}$) für die Schaltung definiert, wobei zumindest zwei Schaltungen der Mehrzahl von Schaltungen unterschiedliche Resonanzfrequenzen haben, mit folgenden Schritten:

    (a) Bestimmen, welche der Schaltungen ($IC_1$, $IC_2$, ...., $IC_n$) anzusteuern ist, durch Wahl einer Frequenz, die der Resonanzfrequenz der anzusteuernden Schaltung(en) entspricht;
    (b) Erzeugen des Ansteuersignals ($U_A$) mit Energiepulsen der gewählten Frequenz, die so klein sind, daß sie das Nutzsignal nicht beeinträchtigen;
(c) Anlegen des erzeugten Ansteuersignals ($U_A$) an die Mehrzahl von Schaltungen; und
(d) Verbinden oder Trennen des Sensors in der angesteuerten Schaltung mit oder von der gemeinsamen Verbindungsleitung, wobei hierzu das Schaltelement zwischen seinen Schaltzuständen vom Schaltungselement (102) umgeschaltet wird.

2. Verfahren nach Anspruch 1, bei dem der Schritt (d) das Gleichrichten des Ausgangssignals ($U_S$) des Schaltungselements (102) und das Aufladen eines Kondensators ($C_B$) durch das gleichgerichtete Ausgangssignal umfaßt.

3. Verfahren nach Anspruch 1 oder 2, bei dem das Schaltungselement (102) ein Serienschwingkreis oder ein Parallelschwingkreis ist, und bei die Güte des Schwingkreises so hoch ist, daß die nötige Frequenzselektivität erreicht wird.

4. verfahren nach Anspruch 2 oder 3, bei dem der Kondensadurch Leckströme entladen wird.

5. Verfahren nach einem der Ansprüche 1 bis 4, bei dem die Schaltungen ($IC_1$, $IC_2$, ...., $IC_n$) durch das Ansteuersignal mit Energie versorgt wird.

6. Schaltungsvorrichtung, mit
einer gemeinsamen Verbindung (100);
einer Mehrzahl von Schaltungen ($IC_1$, $IC_2$, ...., $IC_n$), die über die gemeinsame Verbindung verbunden sind, und die jeweils einen Schalter und einen Sensor, der ein Nutzsignal erzeugt, das an die gemeinsame Verbindungsleitung anlegbar ist, umfassen, wobei der Schalter ein Schaltelement sowie ein Schaltungselement (102) umfaßt, wobei das Schaltungselement eine Resonanzfrequenz ($f_{R1}$, $f_{R2}$, ..., $f_{Rn}$) für die Schaltung definiert, wobei zumindest zwei Schaltungen der Mehrzahl von Schaltungen unterschiedliche Resonanzfrequenzen haben; und einem Steuerelement (ZE), das über die gemeinsame Verbindung (100) mit der Mehrzahl von Schaltungen ($IC_1$, $IC_2$, ...., $IC_n$) verbunden ist, das abhängig von einer anzusteuernden Schaltung ein Ansteuersignal ($U_A$) mit einer Frequenz erzeugt, die der der anzusteuernden Schaltung zugeordneten Resonanzfrequenz entspricht und das das Ansteuersignal ($U_A$) an die gemeinsame Verbindung (100) anlegt, um den Sensor mit der gemeinsamen Verbindungsleitung zu verbinden oder von derselben zu trennen, wobei hierzu das Schaltelement zwischen seinen Schaltzuständen vom Schaltungselement (102) umgeschaltet wird, und wobei das Steuerelement das Ansteuersignal ($U_A$) mit einer Frequenz, die der Resonanzfrequenz der anzusteuernden Schaltung entspricht, und mit Energiepulsen erzeugt, die so klein sind, daß sie das Nutzsignal nicht beeinträchtigen.

7. Schaltungsvorrichtung nach Anspruch 6, bei der jede der Schaltungen ($IC_1$, $IC_2$, ...., $IC_n$) ferner einen Gleichrichter ($D_1$, $D_2$, $D_3$, $D_4$) und einen Kondensator ($C_B$) umfaßt.

8. Schaltungsvorrichtung nach Anspruch 6 oder 7, bei der das Schaltungselement (102) ein Serienschwingkreis oder ein Parallelschwingkreis ist, und bei der die Güte des Schwingkreises so hoch ist, daß die nötige Frequenzselektivität erreicht wird.

9. Schaltungsvorrichtung nach Anspruch 7 oder 8, bei der der Kondensator durch Leckströme entladen wird.

10. Schaltungsvorrichtung nach einem der Ansprüche 6 bis 9, bei der die Schaltungen ($IC_1$, $IC_2$, ...., $IC_n$) durch das Anregungssignal mit Energie versorgt werden.

11. Schaltungsvorrichtung nach einem der Ansprüche 6 bis 10, mit einem Regelelement, das den Stromfluß aus dem Steuerelement (ZE) erfaßt, und die Frequenz des Ansteuersignals (UA) auf die Resonanzfrequenz der anzusteuernden Schaltung einstellt und auf dieser hält.

**Claims**

1. Method for controlling a plurality of circuits ($IC_1$, $IC_2$, ..., $IC_n$) connected to each other via a common connection (100) for receiving a control signal ($U_A$), with each of the plurality of circuits comprising a switch and a sensor, which generates a useful signal, which can be applied to the common connection line, wherein the switch comprises a switching element as well as a circuit element (102), wherein the circuit element (102) defines a resonance frequency ($f_{R1}$, $f_{R2}$, ..., $f_{Rn}$) for the circuit, wherein at least two circuits of the plurality of circuits have different resonance frequencies, comprising the following steps:

(a) determining, which of the circuits ($IC_1$, $IC_2$, ..., $IC_n$) is to be controlled by selecting a frequency, which corresponds to the resonance frequency of the circuit(s) to be controlled;

(b) generating the control signal ($U_A$) with energy pulses of the selected frequency, which are so small that they do not affect the useful signal;

(c) applying the generated control signal ($U_A$) to the plurality of circuits;

(d) connecting or disconnecting the sensor in the controlled circuit to or from the common connection line, wherein the switching element is switched between its switching states by the circuit element (102).

2. Method in accordance with claim 1, wherein the step (d) includes rectifying the output signal ($U_S$) of the circuit element (102) and charging a capacitor ($C_B$) by the rectified output signal.

3. Method in accordance with claim 1 or 2, wherein the circuit element (102) is a series resonance circuit or a parallel resonance circuit and wherein the Q-factor of the resonance circuit is so high that the required frequency selectivity is obtained.

4. Method in accordance with one of claims 2 to 2, wherein the capacitor is discharged by leakage currents.

5. Method in accordance with one of claims 1 to 4, wherein the circuits ($IC_1$, $IC_2$, ..., $IC_n$) are supplied with energy by the control signal.

6. Circuit apparatus, comprising
a common connection (100),
a plurality of circuits ($IC_1$, $IC_2$, ..., $IC_n$), which are connected via the common connection, and each of which comprises a switch and a sensor, which generates a useful signal, which can be applied to the common connection line, wherein the switch comprises a switching element as well as a circuit element (102), wherein the circuit element (102) defines a resonance frequency ($f_{R1}$, $f_{R2}$, ..., $f_{Rn}$) for the circuit, wherein at least two circuits of the plurality of circuits have different resonance frequencies; and
a control element (ZE), which is connected to the plurality of circuits ($IC_1$, $IC_2$, ..., $IC_n$) via the common connection (100), which generates, depending on a circuit to be controlled, a control signal ($U_A$) having a frequency, which corresponds to the resonance frequency assigned to the circuit to be controlled and which applies the control signal ($U_A$) to the common connection (100) to connect or disconnect the sensor to or from the common connection line, wherein therefore the switching element is switched between its switching states by the circuit element (102), wherein the control element generates the control signal ($U_A$) with a frequency, which corresponds to the resonance frequency of the circuit to be controlled, and with energy pulses, which are so small that they do not affect the useful signal.

7. Circuit apparatus in accordance with claim 6, wherein each of the circuits ($IC_1$, $IC_2$, ..., $IC_n$) further comprises a rectifier ($D_1$, $D_2$, $D_3$, $D_4$) and a capacitor ($C_B$).

8. Circuit apparatus in accordance with claim 6 or 7, wherein the circuit element (102) is a series resonance circuit or a parallel resonance circuit and wherein the Q-factor of the resonance circuit is so high that the required frequency selectivity is obtained.

9. Circuit apparatus in accordance with claims 7 or 8, wherein the capacitor is discharged by leakage currents.

10. Circuit apparatus in accordance with one of claims 6 to 9, wherein the circuits ($IC_1$, $IC_2$, ..., $IC_n$) are supplied with energy by the control signal.

11. Circuit apparatus in accordance with one of claims 6 to 10, comprising a regulating element detecting the current flow from the control element (ZE) and adjusting the frequency of the control signal ($U_A$) to the resonance frequency of the circuit to be controlled and keeping it there.

## Revendications

1. Procédé pour commander une pluralité de circuits ($IC_1$, $IC_2$, ..., $IC_n$) reliés entre eux, par l'intermédiaire d'une connexion commune (100), pour recevoir un signal de commande ($U_A$), chacun de la pluralité de circuits comportant un commutateur et un capteur générant un signal utile pouvant être appliqué à la ligne de connexion commune, le commutateur comportant un élément de commutation ainsi qu'un élément de circuit (102), l'élément de circuit (102) définissant une fréquence de résonance ($f_{R1}$, $f_{R2}$, ..., $f_{Rn}$) du circuit, au moins deux circuits de la pluralité de circuits ayant des fréquences de résonance différentes, aux étapes suivantes consistant à :

(a) déterminer lequel parmi les circuits ($IC_1$, $IC_2$, ..., $IC_n$) doit être commandé, par le choix d'une fréquence correspondant à la fréquence de résonance du ou des circuits à commande ;
(b) générer le signal de commande ($U_A$) avec des impulsions d'énergie de la fréquence choisie qui sont aussi petites qu'elles ne dégradent pas le signal utile ;
(c) appliquer le signal de commande généré ($U_A$) à la pluralité de circuits ; et
(d) connecter ou déconnecter le capteur dans le circuit commandé à ou de la ligne de connexion commune, l'élément de commutation étant, à cet effet, commuté entre ses états de commutation par l'élément de circuit (102).

**2.** Procédé selon la revendication 1, dans lequel l'étape (d) comporte le redressement du signal de sortie ($U_S$) de l'élément de circuit (102) et le chargement d'un condensateur ($C_B$) par le signal de sortie redressé.

**3.** Procédé selon la revendication 1 ou 2, dans lequel l'élément de circuit (102) est un circuit oscillateur en série ou un circuit oscillateur parallèle et dans lequel la qualité du circuit oscillateur est si haute que soit atteinte la sélectivité de fréquence nécessaire.

**4.** Procédé selon la revendication 2 ou 3, dans lequel le condensateur est déchargé par des courants de fuite.

**5.** Procédé selon l'une des revendications 1 à 4, dans lequel les circuits ($IC_1$, $IC_2$, ..., $IC_n$) sont alimentés en énergie par le signal de commande.

**6.** Dispositif de commutation, avec
une connexion commune (100) ;
une pluralité de circuits ($IC_1$, $IC_2$, ..., $IC_n$) reliés par l'intermédiaire de la connexion commune (100) et comportant, chacun, un commutateur et un capteur générant un signal utile pouvant être appliqué à la ligne de connexion commune, le commutateur comportant un élément de commutation ainsi qu'un élément de circuit (102), l'élément de circuit (102) définissant une fréquence de résonance ($f_{R1}$, $f_{R2}$, ..., $f_{Rn}$) du circuit, au moins deux circuits de la pluralité de circuits ayant des fréquences de résonance différentes ; et
un élément de commande (ZE) relié, par l'intermédiaire de la connexion commune (100), à la pluralité de circuits ($IC_1$, $IC_2$, ..., $IC_n$), lequel génère, en fonction d'un circuit à commander, un signal de commande ($U_A$) à une fréquence correspondant à la fréquence de résonance associée au circuit à commander et applique le signal de commande ($U_A$) à la connexion commune (100), pour relier le capteur à la connexion commune ou le déconnecter de cette dernière, l'élément de commutation étant, à cet effet, commuté entre ses états de commutation par l'élément de circuit (102), et l'élément de commande générant le signal de commande ($U_A$) avec une fréquence correspondant à la fréquence de résonance du circuit à commander et avec des impulsions d'énergie qui sont aussi petites qu'elles ne dégradent pas le signal utile.

**7.** Dispositif de commutation selon la revendication 6, dans lequel chacun des circuits ($IC_1$, $IC_2$, ..., $IC_n$) comporte, par ailleurs, un redresseur ($D_1$, $D_2$, $D_3$, $D_4$) et un condensateur ($C_B$).

**8.** Dispositif de commutation selon la revendication 6 ou 7, dans lequel l'élément de circuit (102) est un circuit oscillateur en série ou un circuit oscillateur parallèle et dans lequel la qualité du circuit oscillateur est si haute que soit atteinte la sélectivité de fréquence nécessaire.

**9.** Dispositif de commutation selon la revendication 7 ou 8, dans lequel le condensateur est déchargé par des courants de fuite.

**10.** Dispositif selon l'une des revendications 6 à 9, dans lequel les circuits ($IC_1$, $IC_2$, ..., $IC_n$) sont alimentés en énergie par le signal de commande.

**11.** Dispositif selon l'une des revendications 6 à 10, avec un élément de réglage détectant le flux de courant de l'élément de commande (ZE) et réglant la fréquence du signal de commande ($U_A$) à la fréquence de résonance du circuit à commander et la maintenant à cette dernière.

Fig. 1

Fig. 2

Fig. 3

Fig. 4